Europäisches Patentamt

European Patent Office

Office européen des brevets

(19)

(11) EP 1 729 384 A1

(12) EUROPEAN PATENT APPLICATION
published in accordance with Art. 158(3) EPC

(43) Date of publication:
06.12.2006 Bulletin 2006/49

(51) Int Cl.:
*H01S 5/183* (2006.01)

(21) Application number: 05719916.8

(22) Date of filing: 03.03.2005

(86) International application number:
PCT/JP2005/003612

(87) International publication number:
WO 2005/086301 (15.09.2005 Gazette 2005/37)

(84) Designated Contracting States:
DE GB

(30) Priority: 04.03.2004 JP 2004061258

(71) Applicant: FURUKAWA ELECTRIC CO., LTD.
Tokyo 100-8322 (JP)

(72) Inventors:
• ARIGA, Maiko,
THE FURUKAWA ELECTRIC CO., LTD.
Tokyo 1008322 (JP)
• IWAI, Norihiro,
THE FURUKAWA ELECTRIC CO., LTD.
Tokyo 1008322 (JP)

• CASIMIRUS, Setiagung,
FURUKAWA ELECTRIC CO. LTD.
Tokyo 1008322 (JP)
• SHIMIZU, Hitoshi,
THE FURUKAWA ELECTRIC CO., LTD.
Tokyo 1008322 (JP)
• KOYAMA, Fumio
2260027 (JP)
• ARAI, Masakazu
2260027 (JP)

(74) Representative: Schwabe - Sandmair - Marx
Stuntzstrasse 16
81677 München (DE)

(54) SURFACE-EMITTING LASER ELEMENT AND LASER MODULE USING SAME

(57) In a surface-emitting laser element 10 in which a cavity is formed by a lower multilayer mirror 12 and an upper multilayer mirror 16 and an active layer 32 is arranged between the lower multilayer mirror 12 and the upper multilayer mirror 16, carbon is modulation-doped in a barrier layer of the active layer 32 and a differential gain is increased to set a relaxation oscillation frequency in the cavity to exceed an optical communication frequency for modulating a laser light output from the surface-emitting laser element 10. Back-reflection tolerance is improved without decreasing an optical output and simplification and reduction in size of the surface-emitting laser element 10 are realized.

FIG.1

EP 1 729 384 A1

**Description**

TECHNICAL FIELD

The present invention relates to a vertical cavity surface-emitting laser (VCSEL) (hereinafter, "surface-emitting laser element"), and more particularly, to a surface-emitting laser element that can improve critical back-reflection tolerance and a laser module using the surface-emitting laser element.

BACKGROUND ART

In recent years, a surface-emitting laser element has been used in a high-speed communication system with communication speed of 2.5 Gbps to 10 Gbps. In this surface-emitting laser element, a pair of semiconductor multilayer mirrors that use GaAs/AlGaAs or the like are formed on a semiconductor substrate of GaAs, InP, or the like. An active layer serving as a light-emitting region is provided between the pair of semiconductor multilayer mirrors. The surface-emitting laser element emits a laser light in a direction perpendicular to the semiconductor substrate.

Patent Document 1: Japanese Patent Application Laid-Open No. 2004-15027

DISCLOSURE OF INVENTION

PROBLEM TO BE SOLVED BY THE INVENTION

Back-reflection to a light source is caused by reflection in a coupling portion of a light source such as a surface-emitting laser element and an optical fiber or reflection from an optical transmission line such as an optical fiber. This back-reflection causes noise in the light source. Thus, an isolator or the like is inserted in the coupling portion or the like to prevent the back-reflection from being made incident on the light source.

On the other hand, the surface-emitting laser element has been considered to be resistible against back-reflection because reflectance thereof is as high as 99.5%. However, it has been found that the surface-emitting laser element is not always resistible against back-reflection because a cavity length thereof is short. In this case, although it is possible to control the back-reflection by inserting an isolator, cost of a laser module, which uses the surface-emitting laser element, is increased by the insertion of the isolator.

The present invention has been devised in view of the above circumstances and it is an object of the present invention to provide a surface-emitting laser element that can improve back-reflection tolerance without reducing an optical output and can realize reduction in cost and a laser module using the surface-emitting laser element.

MEANS FOR SOLVING PROBLEM

To solve the above problems, and to achieve the object, a surface-emitting laser element according to one aspect of the present invention includes a cavity formed by a lower multilayer mirror and an upper multilayer mirror and an active layer arranged between the lower multilayer mirror and the upper multilayer mirror. A relaxation oscillation frequency at a bias point in the cavity is set to exceed an optical communication frequency for modulating a laser light output from the surface-emitting laser element.

In the surface-emitting laser element according to the present invention, the relaxation oscillation frequency is set by increasing a differential gain.

In the surface-emitting laser element according to the present invention, a p-type impurity is doped in a barrier layer forming the active layer.

In the surface-emitting laser element according to the present invention, a concentration of the doping is in a range between $1 \times 10^{18} \text{cm}^{-3}$ and $2 \times 10^{19} \text{cm}^{-3}$

In the surface-emitting laser element according to the present invention, the p-type impurity includes at least one selected from a group consisting of C, Be, Zn, and Mg.

In the surface-emitting laser element according to the present invention, the cavity is formed by a lower multilayer mirror and an upper multilayer mirror and an active layer is arranged between the lower multilayer mirror and the upper multilayer mirror, and a detuning from a gain peak wavelength at a room temperature to an oscillation wavelength at an operation is performed toward a short wavelength side.

In the surface-emitting laser element according to the present invention, a value of the detuning is a value with which at least a differential gain is increased after the detuning.

In the surface-emitting laser element according to the present invention, a value of the detuning is an energy shift value obtained by converting a wavelength into energy and is a value equal to or less than 20 meV.

In the surface-emitting laser element according to the present invention, an oscillation frequency is in a range between 300 nm and 1600 nm.

The surface-emitting laser element according to the present invention includes a selective oxidation layer obtained by oxidizing a part of a current confinement layer containing at least aluminum and arsenide, to confine an injection current.

In the surface-emitting laser element according to the present invention, a well layer or a barrier layer forming the active layer uses any one of $Ga_{x1}In_{1-x1}N_{y1}As_{y2}Sb_{1-y1-y2}$ ($0 \le x1$, y1, $y2 \le 1$), $Al_{x2}Ga_{x3}In_{1-x2-x3}As$ ($0 \le x2$, $x3 \le 1$), and $Tl_{x4}Ga_{x5}In_{1-x4-x5}As_{y3}P_{1-y3}$ ($0 \le x4$, x5, $y4 \le 1$).

In the surface-emitting laser element according to the present invention, the active layer has any one of a quantum well structure, a quantum wire structure, and a quantum dot structure.

In the surface-emitting laser element according to the present invention, both the upper multilayer mirror and the lower multilayer mirror are semiconductor multilayer films or dielectric multilayer films, or one of the upper multilayer mirror and the lower multilayer mirror is a semiconductor multilayer film and other of the upper multilayer mirror and the lower multilayer mirror is a dielectric multilayer film.

In the surface-emitting laser element according to the present invention, the upper multilayer mirror, the active layer, and the lower multilayer mirror are formed on a GaAs substrate, and the upper multilayer mirror and the lower multilayer mirror are a plurality of pairs of multilayer films of $Al_{x6}Ga_{1-x6}As$ ($0 \le x6 < 1$) and $Al_{x7}Ga_{1-7x}As$ ($0 < x7 \le 1$, $x6 < x7$) set as a pair.

In the surface-emitting laser element according to the present invention, a critical back-reflection, with which a value of relative intensity noise becomes -115 dB/Hz in a region of the optical communication frequency of 0 GHz to 2 GHz, is equal to or larger than -30 dB, and the relaxation oscillation frequency at the bias point is equal to or higher than 5 GHz.

In the surface-emitting laser element according to the present invention, a critical back-reflection, with which a value of relative intensity noise becomes -115 dB/Hz in a region of the optical communication frequency of 0 GHz to 8 GHz, is equal to or larger than -20 dB, the relaxation oscillation frequency at the bias point is equal to or higher than 10 GHz, and an oscillation wavelength is in a 1300-nm band.

In the surface-emitting laser element according to the present invention, a critical back-reflection, with which a value of relative intensity noise becomes -115 dB/Hz in a region of the optical communication frequency of 0 GHz to 8 GHz, is equal to or larger than -30 dB,

the relaxation oscillation frequency at the bias point is equal to or higher than 10 GHz, and

an oscillation wavelength is in a 1550-nm band.

A laser module according to another aspect of the present invention includes a surface-emitting laser element according to any one of claims 1 to 17, and outputs a laser light emitted from the surface-emitting laser element to outside via an optical fiber.

The laser module according to the present invention further includes a CAN-type package.

The laser module according to the present invention further includes an optical fiber receptacle.

The laser module according to the present invention further includes an optical fiber pigtail.

In the laser module according to the present invention, a critical back-reflection, with which a value of relative intensity noise becomes -115 dB/Hz in a region of the optical communication frequency of 0 GHz to 2 GHz, is equal to or larger than -30 dB, and the relaxation oscillation frequency at the bias point is equal to or higher than 5 GHz.

In the laser module according to the present invention, a critical back-reflection, with which a value of relative intensity noise becomes -115 dB/Hz in a region of the optical communication frequency of 0 GHz to 8 GHz, is equal to or larger than -20 dB, the relaxation oscillation frequency at the bias point is equal to or higher than 10 GHz, and an oscillation wavelength is in a 1300-nm band.

In the laser module according to the present invention, a critical back-reflection, with which a value of relative intensity noise becomes -115 dB/Hz in a region of the optical communication frequency of 0 GHz to 8 GHz, is equal to or larger than -30 dB, the relaxation oscillation frequency at the bias point is equal to or higher than 10 GHz, and an oscillation wavelength is in a 1550-nm band.

EFFECT OF THE INVENTION

In the surface-emitting laser element and the laser module using the surface-emitting laser element according to the present invention, a relaxation oscillation frequency at the bias point in the cavity is set to exceed an optical communication frequency for modulating a laser light output from the surface-emitting leaser element. Specifically, a p-type impurity is doped in the barrier layer forming the active layer or detuning to an oscillation wavelength at the time of an operation from a gain peak wavelength at the time of the room temperature is performed toward a short wavelength side. Consequently, a differential gain is increased, the relaxation oscillation frequency is increased to be set to exceed the optical communication frequency, and back-reflection tolerance is improved. Thus, there is an effect that it is possible to improve back-reflection tolerance without reducing an optical output by increasing reflectance and realize reduction in cost of the laser module.

BRIEF DESCRIPTION OF DRAWINGS

Fig. 1 is a cross section of a surface-emitting laser element according to a first embodiment of the present invention viewed from an oblique direction;
Fig. 2 is a cross section of a detailed structure near an active layer;
Fig. 3 is a graph of relaxation-oscillation-frequency dependency of critical back-reflection;
Fig. 4 is a graph of modulation-doping-amount dependency of critical back-reflection;
Fig. 5 is a graph of a change in RIN with respect to the back-reflection;
Fig. 6 is a graph of a frequency characteristic of RIN;
Fig. 7 is a graph of reflectance dependency of critical back-reflection with a relaxation oscillation frequency set as a parameter;
Fig. 8 is a graph of a gain spectrum for explaining detuning in a direction for increasing a differential gain;
Fig. 9 is a graph of detuning-amount dependency of critical back-reflection; and
Fig. 10 is a graph of a relation between detuning that occurs in a surface-emitting laser element formed on a wafer and an oscillation wavelength.

EXPLANATIONS OF LETTERS OR NUMERALS

| 10 | Surface-emitting laser element |
| 11 | n-GaAs substrate |
| 12 | Lower multilayer mirror |
| 13 | Active region |
| 14 | Selective oxidation layer |
| 15 | Current confinement layer |
| 16 | Upper multilayer mirror |
| 17 | Contact layer |
| 18 | P-side electrode |
| 19 | Silicon nitride film |
| 20 | Electrode pad |
| 21 | n-GaAs buffer layer |
| 22 | Polyimide |
| 31, 33 | Cladding layers |
| 32 | Active layer |
| 41a to 41d | Barrier layers |
| 42a to 42c | Quantum well layers |

| $\lambda$g | Gain peak wavelength. |
| $\lambda$lasing | Oscillation wavelength |
| L11, L12 | Gain curves |

BEST MODE(S) FOR CARRYING OUT THE INVENTION

A surface-emitting laser element and a laser module using the surface-emitting laser element, which are best modes for carrying out the present invention, are explained below.

(First Embodiment)

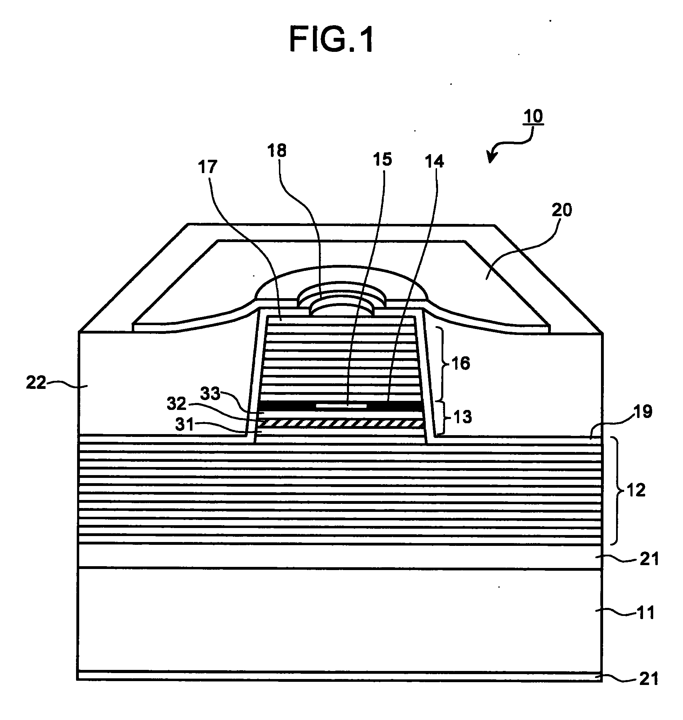

A surface-emitting laser element according to a first embodiment is explained. Fig. 1 is a cross section of the surface-emitting laser element according to the first embodiment of the present invention viewed from an oblique direction. In Fig. 1, a surface-emitting laser element 10 has a structure in which an n-GaAs buffer layer ($n=1\times10^{18}$ cm$^{-3}$) 21, a lower multilayer mirror 12, an active region 13, an upper multilayer mirror 16 including a current confinement layer 15, and a contact layer 17 are stacked on an n-GaAs substrate 11 of a (001) surface one after another, an n-side electrode 21 is provided below the n-GaAs substrate 11, and a ring-shaped p-side electrode 18 and an electrode pad 20 for leading the p-side electrode 18 are provided above the contact layer 17. The active region 13, the upper multilayer mirror 16, and the p-side electrode 18 form a cylindrical mesa post with the periphery thereof removed. A sidewall of the mesa post and an upper portion of the lower multilayer mirror 12 are covered with a silicon nitride film 19. The periphery of the mesa post is filled with a polyimide 22 via the silicon nitride film 19.

The lower multilayer mirror 12 has a structure in which 25.5 pairs of multilayer films with AlAs and GaAs set as a pair are stacked from the n-GaAs substrate 11 side and ten pairs of multilayer films with $Al_{10.9}Ga_{0.1}As$ and GaAs set as a pair are stacked above the 25.5 pairs of multilayer films. The active region 13 has an active layer 32 sandwiched by Cladding layers 31 and 33. The active layer 32 forms a multiple quantum well structure of $Ga_{0.63}In_{0.37}N_{0.01}As_{0.974}Sb_{0.016}$ (a quantum well layer)/$GaAs_{0.93}P_{0.07}$ (a barrier layer) and has three quantum well layers. Carbon with $p=5\times10^{18}cm^{-3}$ is doped in the barrier layer. The upper multilayer mirror 16 has a structure in which twenty-three or twenty-six multilayer films with $Al_{0.9}Ga_{0.1}As$ and GaAs set as a pair is stacked. An oscillation wavelength of the surface-emitting laser element 10 is about 1310 nm.

A method of manufacturing the surface-emitting laser element 10 is explained. First, the n-GaAs buffer layer $(n=1\times10^{18}cm^{-3})$ 21, the lower multilayer mirror 12, the active region 13, the upper multilayer mirror 16, and the contact layer 17 formed of GaAs are stacked on the n-GaAs substrate 11 one after another according to the metal organic chemical vapor deposition (MOCVD) method. The current confinement layer 15 formed of AlAs with thickness of 20 nm is stacked as a lowermost layer of the upper multilayer mirror 12.

Thereafter, a silicon nitride film is formed on a growing surface of the contact layer 17 according to the plasma CVD method. A circular pattern with a diameter of about 40 $\mu$m to 45 $\mu$m is transferred onto the silicon nitride film using the photolithography by a photoresist. The silicon nitride film is etched using the circular resist mask transferred according to the reactive ion etching (RIE) method that uses a $CF_4$ gas. The etching is further performed according to the reactive ion beam etching (RIBE) method that uses a chloride gas until the etching reaches the lower multilayer mirror 12 to form a mesa post of a columnar structure. Depth of the etching by the RIBE method is set to stop the etching in the lower multilayer mirror 12.

In this state, the stacked layers are heated to 400°C in a water vapor atmosphere and left as they are to selectively oxidize the current confinement layer 15 in the lowermost layer of the upper multilayer mirror 16. Consequently, a selective oxidation layer 14 is formed. A current injection path of the current confinement layer 15 in which the selective oxidation layer 14 is not formed is 3 $\mu$m to 10 $\mu$m in diameter. Thereafter, after completely removing the silicon nitride film according to the RIE method, the periphery of the mesa post is filled with the polyimide 22.

Moreover, a silicon nitride film is formed over the entire surface again according to the plasma CVD method. Thereafter, the silicon nitride film in the upper portion of the mesa post is removed in a circular shape. The p-side electrode 18, which is a ring-shaped AuGeNi/Au electrode, is formed in the portion where the silicon nitride film is removed. The electrode pad 20 of Ti/Pt/Au is formed for electrode leading. An area of the electrode pad 20 is 300 $\mu$m2. Thereafter, after grinding the n-GaAs substrate 11 to about 200 $\mu$m, the AuGeNi/Au electrode is deposited on the surface of the n-GaAs substrate 11. Finally, the stacked layers are annealed at about 400°C in a nitrogen atmosphere.

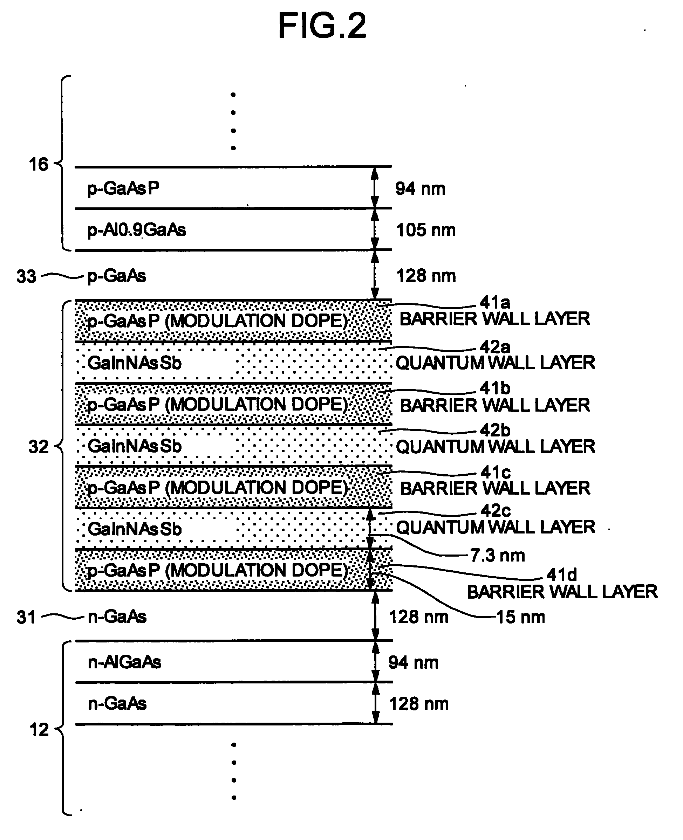

Fig. 2 is a diagram of a sectional structure near the active region 13. As shown in Fig. 2, the active layer 32 has a triple quantum well structure in which three quantum well layers 42a to 42c made of $Ga_{0.63}In_{0.37}N_{0.01}As_{0.974}Sb_{0.016}$ with thickness of 7.3 nm are sandwiched among four barrier layers 41a to 41d made of $GaAs_{0.93}P_{0.07}$ with thickness of 15 nm. As described above, carbon with $p=5\times10^{18}cm^{-3}$ is doped in the respective barrier layers 41a to 41d. The Cladding layers 31 and 33 with thickness of 128 nm are provided above and below the active layer 32. Thickness of each of the upper multilayer mirror 16 and the lower multilayer mirror 12 is $\lambda/4$.

In the surface-emitting laser element 10, it is possible to increase back-reflection tolerance by doping the p-type impurity in the barrier layers 41a to 41d. When there is back-reflection to a semiconductor laser element, a noise level at which noise suddenly increases depends on a characteristic of the semiconductor laser element. In general, a critical back-reflection fextc in an edge emitting laser element is represented by

$$fextc=(t_L^2/16|C_e|^2)\cdot(K\cdot fr^2+1/t_e)^2\cdot((1+a^2)/a^4) \qquad (1)$$

where $\tau_L$ is a light confinement time of a cavity, $C_e$ is efficiency of coupling with back-reflection at a laser emission end, K is a K factor, fr is a relaxation oscillation frequency, $\tau_e$ is an electron life, and $\alpha$ is a spectral-linewidth enhancement factor.

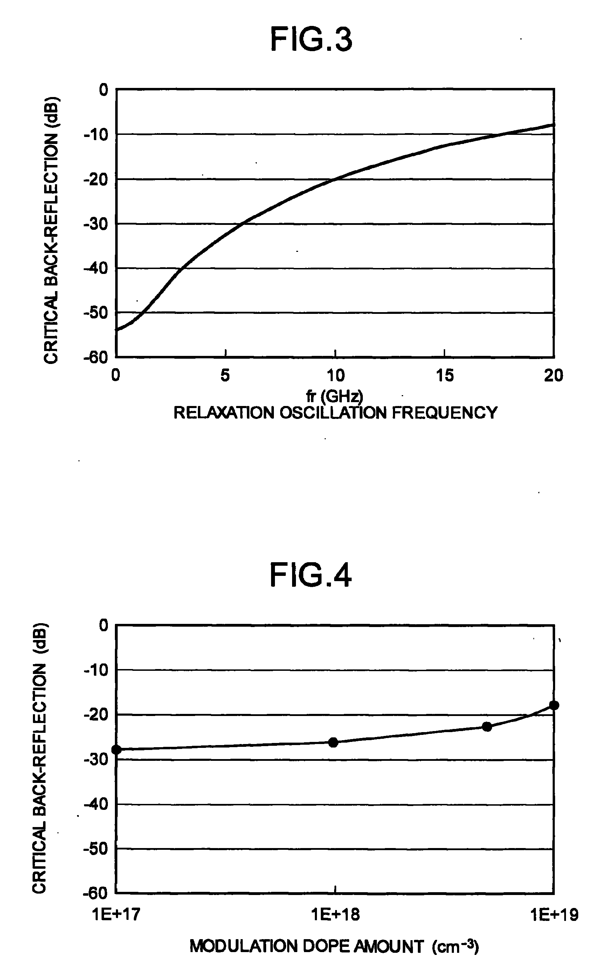

Increasing the critical back-reflection fextc means increasing back-reflection tolerance. It has been found that, in the case of the surface-emitting laser element, to increase the critical back-reflection fextc without spoiling an optical output, an increase in the relaxation oscillation frequency fr contributes most. Fig. 3 is a diagram of relaxation-oscillation-frequency fr dependency of the critical back-reflection fextc. As shown in Fig. 3, the critical back-reflection fextc increases according to an increase in the relaxation frequency fr. For example, when the relaxation frequency fr is 5 GHz, the critical back-reflection fextc is about -30 dB. When the relaxation frequency fr is increased to 20 GHz, the critical back-reflection fextc increases to about -10 dB. In other words, even if there is back-reflection as large as -10 dB, it is possible to control noise that occurs in the surface-emitting laser element.

The relaxation oscillation frequency fr has a relation expressed by

$$fr \propto (a(dg/dn) \cdot (I-Ith))^{1/2} \qquad\qquad (2)$$

Therefore, to increase the relaxation oscillation frequency fr, a differential gain (dg/dn) and a current injection amount (I-Ith) only have to be increased. The current injection amount (I-Ith) is a dynamic amount of an electric current injected into the surface-emitting laser element. Thus, it is seen that the differential gain (dg/dn) only has to be increased.

It is possible to realize the increase of the differential gain (dg/dn) by doing an impurity in the barrier layers 41a to 41d of the active layer 32. Fig. 4 is a graph of modulation-doping-amount dependency of the critical back-reflection fextc. As shown in Fig. 4, when a doping amount in the barrier layers 41a to 41d are increased, the critical back-reflection fextc increases. For example, when the modulation doping amount is changed from $p=1\times10^{17}cm^{-3}$ to $p=1\times10^{19}cm^{-3}$, it is possible to increase the critical back-reflection fextc by about 10 dB.

According to the first embodiment, carbon with $p=5\times10^{18}cm^{-3}$ is doped.

In the surface-emitting laser element 10 according to the first embodiment, an opening area formed by the selective oxidation layer 14 is 30 $\mu m^2$. Continuous wave at a threshold current of 1 mA, slope efficiency of 0.3 W/A, and 100°C was obtained. The relaxation oscillation frequency fr in this case was 6 GHz at a bias current of 5 mA when modulation doping for the barrier layers was not performed. The relaxation oscillation frequency fr was successfully increased to 9 GHz by performing the modulation doping. In other words, as shown in Fig. 3, a critical back-reflection was successfully increased from -28 dB to -22 dB.

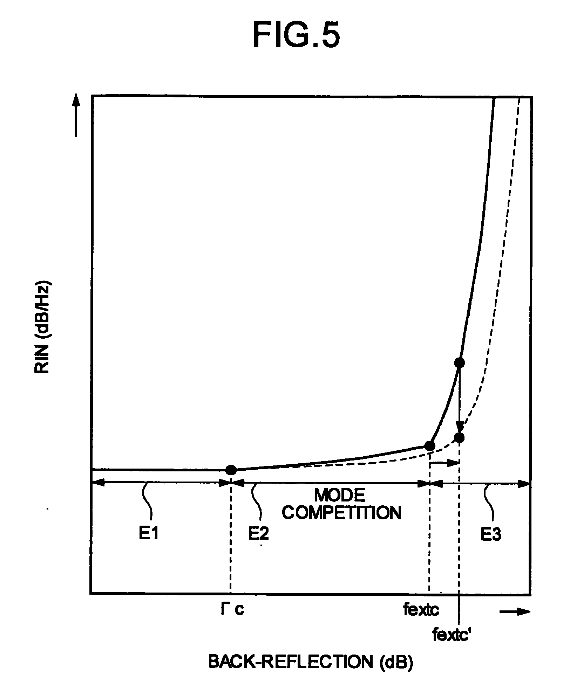

Back-reflection dependency of relative intensity noise that occurs in the surface-emitting laser element 10 is considered. As shown in Fig. 5, the RIN increases according to an increase in back-reflection. There are two critical points of the RIN. One critical point is a critical point Γc where mode competition between a cavity mode of the surface-emitting laser element itself and an external cavity mode. The other critical point is a critical point (critical back-reflection) fextc due to coherent collapse. When a distance between the surface-emitting laser element and a reflection point of the back-reflection decreases, the critical point Γc and fextc are closer to each other. The RIN slightly increases when the RIN passes the critical point Γc according to the increase in the back-reflection. The RIN suddenly increases when the RIN passes the critical point fextc. Therefore, it is possible to control occurrence of large RIN by increasing a value of the critical point fextc. In other words, as shown in Fig. 5, when the critical point fextc is changed to a critical point fextc', a characteristic curve of the RIN and the back-reflection is deformed to an increasing side of the back-reflection. Thus, it is possible to expand back-reflection regions E1 and E2 where the value of the RIN is small and increase large back-reflection tolerance. This critical point fextc is the critical back-reflection fextc described above.

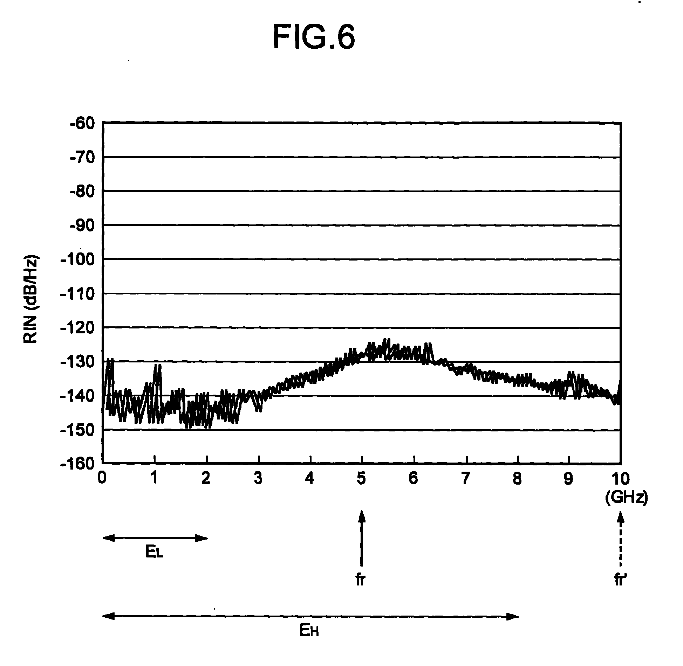

Optical communication performed using this surface-emitting laser element is considered. Fig. 6 is a graph of a frequency characteristic of the RIN. As shown in Fig. 6, the RIN takes a large value near the relaxation oscillation frequency fr. In Fig. 6, since the relaxation oscillation frequency fr is 5 GHz, a value of the RIN near the relaxation oscillation frequency fr is large. When transmission speed of the optical communication is about 2 GHz, it is possible to perform communication without being affected by the relaxation oscillation frequency fr. However, when the transmission speed of the optical communication is increased to about 8 GHz, the relaxation oscillation frequency of 5 GHz affects communication as noise. In this case, if the relaxation oscillation frequency is shifted to a relaxation oscillation frequency fr' that exceeds a communication frequency band $E_R$ of 0 to 8 GHz and at which noise due to a relaxation oscillation frequency does not affect the communication frequency band $E_H$, a value of the RIN decreases and it is possible to perform satisfactory communication. According to the first embodiment, since the relaxation oscillation frequency is successfully shifted from 6 GHz to 9 GHz, it is possible to hold down a value of the RIN at the time of communication with transmission speed of, for example, about 8 GHz.

A differential gain is increased by the modulation doping, a relaxation oscillation frequency is increased by the increase in the differential gain, and a value of the RIN is reduced by the increase in the relaxation oscillation frequency. This makes it possible to increase critical back-reflection tolerance.

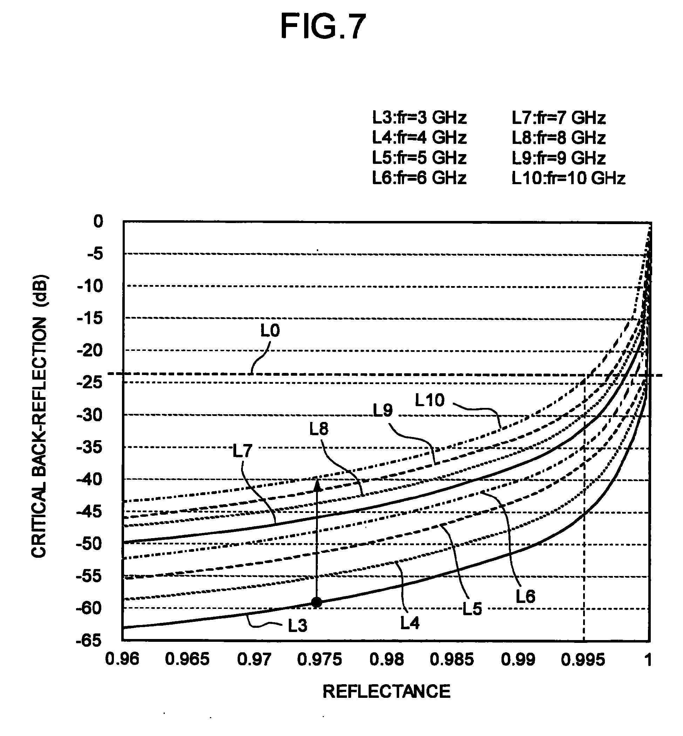

A critical back-reflection increases according to the increase in the relaxation oscillation frequency and also increases according to an increase in reflectance of the upper multilayer mirror 16. Fig. 7 is a graph of dependency on reflectance of a critical back-reflection at the time when a relaxation oscillation frequency is set as a parameter. As shown in Fig. 7, the critical back-reflection not only increases according to the increase in the relaxation oscillation frequency but also increases according to the increase in the reflectance of the upper multilayer mirror 16. The increase in the reflectance means reduction of an output of the surface-emitting laser element. On the other hand, it is not easy to increase an output of the surface-emitting laser element. Therefore, the increase in the relaxation oscillation frequency by the modulation doping makes it possible to increase back-reflection tolerance without decreasing an optical output of the surface-emitting laser element and also makes it possible to perform satisfactory high-speed communication. For example, in Fig. 7, the relaxation oscillation frequency is set to 10 GHz, -24 dB of a critical back-reflection standard for a DFB laser element in the present situation is cleared by setting the reflectance to 0.995 and setting the relaxation oscillation frequency to 10 GHz.

Examples of the surface-emitting laser element subjected to the modulation doping include the following. A surface-emitting laser element in a long wavelength band that has the critical back-reflection fextc, with which a value of the RIN at 0 GHz to 2 GHz becomes -115 dB/Hz, equal to or larger than -30 dB and the relaxation oscillation frequency fr at a bias point equal to or higher than 5 GHz is realized. This makes it possible to satisfactorily perform communication at transmission speed of 2.6 Gbps. A surface-emitting leaser element in a 1.3-$\mu$m band that has the critical back-reflection fextc, with which a value of the RIN at 0 GHz to 8 GHz becomes -115 dB/Hz, equal to or larger than -20 dB and the relaxation oscillation frequency fr at a bias point equal to or higher than 10 GHz is realized. This makes it possible to satisfactorily perform communication at transmission speed of 10 Gbps. Moreover, a surface-emitting laser element in a 1.55-$\mu$m band that has the critical back-reflection fextc, with which a value of the RIN at 0 GHz to 8 GHz becomes - 115 dB/Hz, equal to or larger than -30 dB and the relaxation oscillation frequency fr at a bias point equal to or higher than 10 GHz is realized. This makes it possible to satisfactorily perform communication at transmission speed of 10 Gbps.

According to the first embodiment, modulation doping density is p=$5\times10^{18}$cm$^{-3}$. However, the modulation doping density is preferably set to p=$1\times10^{18}$cm$^{-3}$ to p=$2\times10^{19}$cm$^{-3}$. According to the first embodiment, carbon is used as the p-type impurity for performing p--type doping. However, the p-type impurity is not limited to carbon. Be, Zn, Mg, or the like may be used as the p-type impurity. These kinds of materials may be simultaneously used.

Furthermore, according to the first embodiment, the semiconductor film is used for both the upper multilayer mirror 16 and the lower multilayer mirror 12. However, the multilayer mirrors are not limited to the semiconductor film. For example, a dielectric film may be used. According to the first embodiment, the lower multilayer mirror is formed by the multilayer films with AlAs/GaAs set as a pair and the upper multilayer mirror is formed by the multilayer films with $Al_{0.9}Ga_{0.1}As$/GaAs set as a pair. However, it is also possible to form both the multilayer mirrors with multilayer films with AlGaAs/AlGaAs having different Al compositions set as a pair. Moreover, it is also possible to provide gradient composition layers in which compositions are gradually changed may be provided among these respective layers.

Moreover, according to the first embodiment, GaInNAsSb is used as the quantum well layers 42a to 42c. However, a material of the quantum well layers 42a to 42c is not limited to this material. For example, an AlGaInAs semiconductor material, a GaInAsP semiconductor material, an InGaAsSb semiconductor material, a TlGaInAsP semiconductor material, or the like may be used. According to the first embodiment, the active layer 32 has the quantum well structure. However, the active layer 32 is not limited to this structure. The active layer 32 may have a quantum wire structure or a quantum dot structure.

Furthermore, according to the first embodiment, the surface-emitting laser element is the surface-emitting laser element having an oscillation wavelength of about 1310 nm. However, it is also possible to form a surface-emitting laser element having other oscillation wavelengths, for example, an oscillation wavelength in a 300-nm to 1600-nm band. For example, it is also possible to form a surface-emitting laser element having an oscillation wavelength in an 850-nm band. However, in this case, a quantum well layer is formed of GaAs or AlGaInAs.

Moreover, according to the first embodiment, back-reflection tolerance of the surface-emitting laser element itself is described. However, the present invention is not limited to this back-reflection tolerance. It is also possible to apply the present invention to back-reflection tolerance with a laser module including this surface-emitting laser element set as a unit. In the laser module, the surface-emitting laser element is bonded to a CAN packet, other plastic packages, or the like. An optical fiber receptacle or a pigtail is attached to the laser module. In this case, since the back-reflection tolerance is high, an optical element such as an isolator does not have to be mounted. Thus, it is possible to realize reduction in cost of the laser module itself.

When this laser module is set as a unit, since a loss due to coupling of the surface-emitting laser element and an optical fiber is intrinsic, a critical back-reflection decreases in appearance. When the loss due to coupling is about 3 dB, the critical back-reflection increases by a loss of 6 dB from the surface-emitting laser element to the optical fiber and vice versa. As a result, a laser module having a surface-emitting laser element in the long wavelength band that has the critical back-reflection fextc, with which a value of the RIN at 0 GHz to 2 GHz becomes -115 dB/Hz, equal to or larger than -24 dB and the relaxation oscillation frequency fr at a bias point equal to or higher than 5 GHz is realized. This makes it possible to satisfactorily perform communication at transmission speed of 2.5 Gbps. A laser module having a surface-emitting laser element in the 1.3-$\mu$m band that has the critical back-reflection fextc, with which a value of the RIN at 0 GHz to 8 GHz becomes -115 dB/Hz, equal to or larger than -14 dB and the relaxation oscillation frequency fr at a bias point equal to or higher than 10 GHz is realized. This makes it possible to satisfactorily perform communication at transmission speed of 10 Gbps. Moreover, a laser module having a surface-emitting laser element in the 1.55-$\mu$m band that has the critical back-reflection, with which a value of the RIN at 0 GHz to 8 GHz becomes - 115 dB/Hz, equal to or larger than -24 dB and the relaxation oscillation frequency fr at a bias point equal to or higher than 10 GHz is realized. This makes it possible satisfactorily perform communication at transmission speed of 10 Gbps.

(Second Embodiment)

A second embodiment of the present invention is explained. According to the first embodiment, the modulation doping is applied to the barrier layers 41a to 41d as means for increasing the relaxation oscillation frequency fr. However, according to the second embodiment, detuning is performed to increase a differential gain, whereby the relaxation oscillation frequency fr is increased.

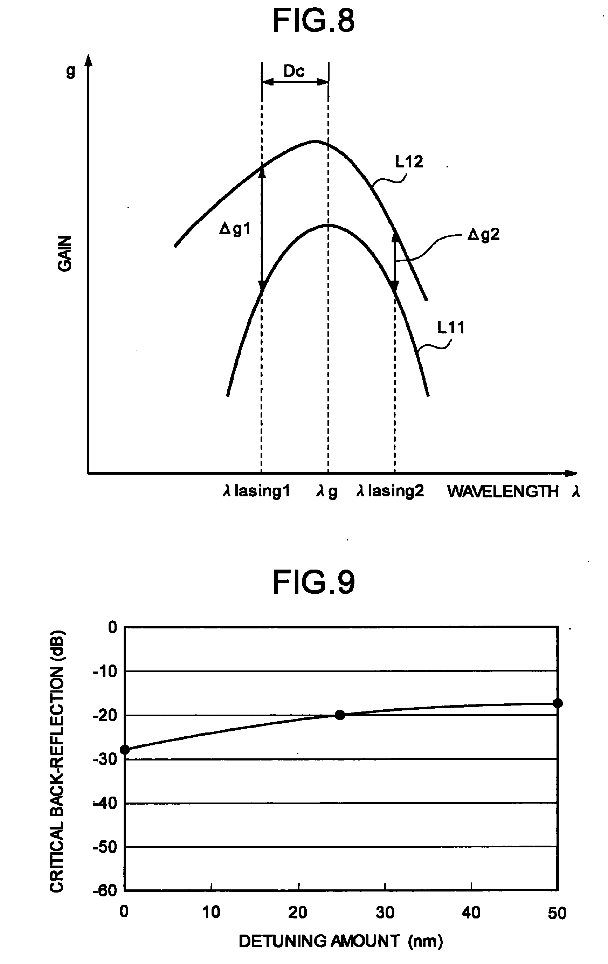

It is possible to increase the differential gain (dg/dn) of the relaxation oscillation frequency fr shown in Equation (2) not only with the demodulation doping but also with the detuning. Fig. 8 is a graph for explaining an increase in a differential gain by the detuning. In Fig. 8, a gain of a laser light has wavelength dependency and temperature dependency. On a gain curve L11 at the time of a room temperature operation, a gain decreases to a short wavelength side and a long wavelength side with a gain peak wavelength λg1 as a peak. Similarly, on a gain curve L12 at the time of a low temperature operation, a gain decreases to a short wavelength side and a long wavelength side with a gain peak wavelength λg2 as a peak. On the gain curve L12 at the time of the low temperature operation, a high gain is generally obtained compared with the gain curve L11 at the time of the room temperature operation. An oscillation wavelength λ1 is an oscillation wavelength at the time of the room temperature operation and coincides with the gain peak wavelength λg1. An oscillation wavelength λ2 is an oscillation wavelength of oscillation shifted to the short wavelength side by the detuning at the time of the low temperature operation. The oscillation wavelength λ2 may coincide with the gain peak wavelength λg2.

The detuning according to the second embodiment is different from usual detuning. In the usual detuning, a gain curve is shifted to the long wavelength side at the time of a high temperature operation and an oscillation wavelength is shifted to a high temperature side. However, since respective shift amounts are different, this deviation is corrected to adjust the oscillation wavelength to a high gain state at the time of the high temperature operation. On the other hand, in the detuning according to the second embodiment, unlike the usual detuning, an oscillation wavelength is shifted to the short wavelength side.

The detuning is defined as a difference Dc between a gain peak wavelength λg and an oscillation wavelength λlasing at the room temperature (Dc=λg-λlasing). In Fig. 8, a gain spectrum L11 at the time of low current inject at the time of the room temperature, a gain spectrum L12 at the time of high current injection, and set oscillation wavelength λlasing1 and λlasing2 at the room temperature are shown. The differential gain (dg/dn) is Δg/Δn at the oscillation wavelength λlasing. As shown in Fig. 8, the differential gain (dg/dn) is larger when the gain peak wavelength λg is set larger than the oscillation wavelength λlasing.

Fig. 9 is a graph of detuning-amount dependency of the critical back-reflection. As shown in Fig. 9, according to an increase in a detuning amount shifted to the short wavelength side, the critical back-reflection increases. It is possible to obtain critical back-reflection equal to or higher than -30 dB. In particular, when the detuning amount is set as large as 50 nm, it is possible to increase the critical back-reflection to near - 20 dB.

A surface-emitting laser element, which was the surface-emitting laser element described according to the first embodiment and was not subjected to the modulation doping, was manufactured. In the surface-emitting laser element, barrier layers corresponding to the barrier layers 41a to 41d were formed of GaAs, thickness of the barrier layers was set to 20 nm, a cavity length was adjusted, the oscillation wavelength λlasing at the time of the room temperature operation was set to 1300 nm, and the gain peak wavelength $λ_g$ was set to 1325 nm. Thickness of the respective multilayer films of the upper multilayer mirror 16 and the lower multilayer mirror 12 is also adjusted to be λ/4. This surface-emitting laser element has an opening area of 30 $\mu m^2$ and continuously oscillates at a threshold current of 1.5 mA and slope efficiency of 0.25 W/A. When the detuning to the short wavelength side of +25 nm was performed, the relaxation oscillation frequency fr increased from 6 GHz to 10 GHz. When optical communication of 10 Gbps was actually performed, satisfactory communication was successfully performed without any jitter or the like in an eye pattern.

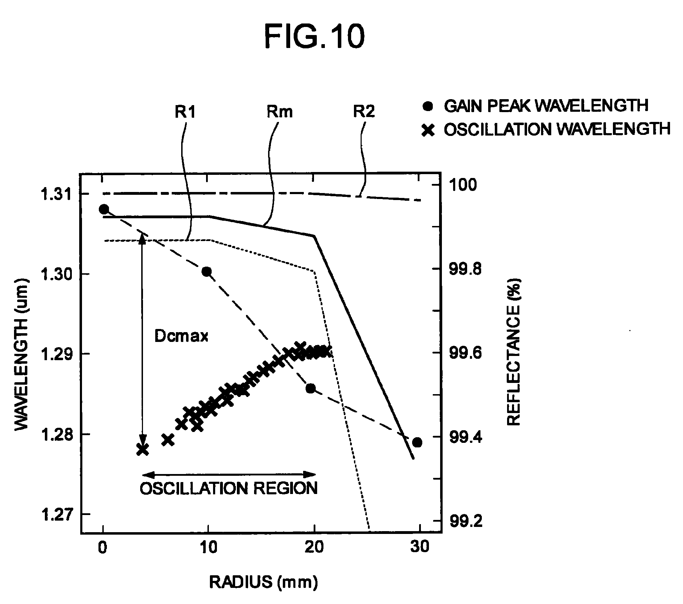

A result obtained by applying the detuning to a plurality of surface-emitting laser element formed on a wafer using an error in manufacturing is explained. Fig. 10 is a graph for explaining a range of a detuning amount on the wafer. In Fig. 10, a characteristic curve R1 indicates reflectance of the upper multilayer mirror 16, a characteristic curve R2 indicates reflectance of the lower multilayer mirror 12, and a characteristic curve Rm indicates a geometric mean of the upper multilayer mirror 16 and the lower multilayer mirror 12. A black circle mark indicates a gain peak wavelength at the time of the room temperature operation and an X mark indicates an oscillation wavelength at the time of the room temperature operation. As shown in Fig. 10, the gain peak wavelength is shifted to the short wavelength side as a radius (a distance) from the center of the wafer increases. The oscillation wavelength is shifted to the long wavelength side as the distance from the center of the wafer increases. When the distance from the center of the wafer reaches near 20 mm, reflectance suddenly decreases and, according to the decrease, the surface-emitting laser elements stop oscillating. As described above, a value calculated by subtracting an oscillation wavelength at the time of the room temperature operation from a gain peak wavelength at the time of the room temperature operation is a detuning amount. Thus, in Fig. 10, a largest detuning amount Dcmax is obtained in a surface-emitting laser element placed at a distance from the center of about 3 mm. Therefore, in the surface-emitting laser element in the 1.3-$\mu$m band, it is possible to perform the detuning to about 0 nm to 25 nm, or about 0 meV to 20 meV.

The respective surface-emitting laser elements on the wafer are elements in the 1.3-$\mu$m band. However, it is possible to apply the detuning to about 0 nm to 35 nm (about 0 meV to 20 meV) to a surface-emitting laser element in the 1.55-$\mu$m band. This indicates that a detuning amount (a wavelength) in the 1.3-$\mu$m band only has to be converted into energy and set as an energy shift amount. This means that it is possible to apply detuning for causing energy shift of 20 meV to the respective surface-emitting laser element in the 1.3-$\mu$m band and the 1.55-$\mu$m band.

The surface-emitting leaser element described above is a surface-emitting laser element in the 1.3-$\mu$m band. However, it goes without saying that it is also possible to increase a differential gain by applying the detuning to the short wavelength side to the surface-emitting laser element in the 1.55-$\mu$m band and increase a relaxation oscillation frequency to thereby increase back-reflection tolerance.

For example, a surface-emitting laser element, which was the surface-emitting laser element described according to the first embodiment and was not subjected to the modulation doping, was manufactured. In the surface-emitting laser element, the quantum well layers 42a to 42c were formed of $Ga_{0.55}In_{0.45}N_{0.025}As_{0.945}Sb_{0.03}$, barrier layers corresponding to the barrier layers 41a to 41d were formed of $GaN_{0.02}As_{0.9}Sb_{0.08}$, thickness of the quantum well layers and the barrier layers was set to 20 nm, a cavity length was adjusted, and the gain peak wavelength $\lambda$g at the time of the room temperature operation was set to 1580 nm and the oscillation wavelength $\lambda$lasing at the time of the room temperature operation was set to 1550 nm. Thickness of the respective multilayer films of the upper multilayer mirror 16 and the lower multilayer mirror 12 is also adjusted to be $\lambda/4$. This surface-emitting laser element has an opening area of 30 $\mu$m$^2$ and continuously oscillates at a threshold current of 1.5 mA and slope efficiency of 0.25 W/A. When the detuning to the short wavelength side of +30 nm was performed, the relaxation oscillation frequency fr increased from 6 GHz to 10 GHz. When optical communication of 10 Gbps was actually performed, satisfactory communication was successfully performed without any jitter or the like in an eye pattern.

According to the second embodiment, a differential gain is increased by performing the detuning to the short wavelength side and the relaxation oscillation frequency fr is increased by the increase in the differential gain, whereby a surface-emitting laser element with large back-reflection tolerance is realized without decreasing an output.

Furthermore, according to the second embodiment, the modulation doping described according to the first embodiment is not applied. However, the modulation doping may be applied according to the second embodiment. This makes it possible to further improve a differential gain and, as a result, realize a surface-emitting laser element with larger back-reflection tolerance without decreasing an output.

When the detuning according to the second embodiment is applied, for example, a surface-emitting laser element in the long wavelength band that has the critical back-reflection fextc, with which a value of the RIN at 0 GHz to 2 GHz becomes -115 dB/Hz, equal to or larger than -30 dB and the relaxation oscillation frequency fr at a bias point equal to or higher than 5 GHz is realized. This makes it possible to satisfactorily perform communication at transmission speed of 2.5 Gbps. A surface-emitting laser element in the 1.3-$\mu$m band that has the critical back-reflection fextc, with which a value of the RIN at 0 GHz to 8 GHz becomes -115 dB/Hz, equal to or larger than -20 dB and the relaxation oscillation frequency fr at a bias point equal to or higher than 10 GHz is realized. This makes it possible to satisfactorily perform communication at transmission speed of 10 Gbps. Moreover, a surface-emitting laser element in the 1.55-$\mu$m band that has the critical back-reflection fextc, with which a value of the RIN at 0 GHz to 8 GHz becomes -115 dB/Hz, equal to or larger than -30 dB and the relaxation oscillation frequency fr at a bias point equal to or higher than 10 GHz is realized. This makes it possible to satisfactorily perform communication at transmission speed of 10 Gbps.

Moreover, according to the second embodiment, the semiconductor film is used for both the upper multilayer mirror 16 and the lower multilayer mirror 12. However, the multilayer mirrors are not limited to the semiconductor film. For example, a dielectric film may be used. According to the second embodiment, the lower multilayer mirror is formed by the multilayer films with AlAs/GaAs set as a pair and the upper multilayer mirror is formed by the multilayer films with $Al_{0.9}Ga_{0.1}As$/GaAs set as a pair. However, it is also possible to form both the multilayer mirrors with multilayer films with AlGaAs/AlGaAs having different Al compositions set as a pair. Moreover, it is also possible to provide gradient composition layers in which compositions are gradually changed may be provided among these respective layers.

Furthermore, according to the first embodiment, GaInNAsSb is used as the quantum well layers 42a to 42c. However, a material of the quantum well layers 42a to 42c is not limited to this material. For example, an AlGaInAs semiconductor material, a GaInAsP semiconductor material, an InGaAsSb semiconductor material, a TlGaInAsP semiconductor material, or the like may be used. According to the first embodiment, the active layer 32 has the quantum well structure. However, the active layer 32 is not limited to this structure. The active layer 32 may have a quantum wire structure or a quantum dot structure.

Moreover, according to the second embodiment, the surface-emitting laser element is the surface-emitting laser element having an oscillation wavelength in the 1310-nm band and the 1550-nm band. However, it is also possible to form a surface-emitting laser element having other oscillation wavelengths, for example, an oscillation wavelength in a 300-nm to 1600-nm band. For example, it is also possible to form a surface-emitting laser element having an oscillation wavelength in an 850-nm band. However, in this case, a quantum well layer is formed of GaAs.

Furthermore, according to the second embodiment, back-reflection tolerance of the surface-emitting laser element itself is described. However, the present invention is not limited to this back-reflection tolerance. It is also possible to apply the present invention to back-reflection tolerance with a laser module including this surface-emitting laser element set as a unit. In the laser module, the surface-emitting laser element is bonded to a CAN packet, other plastic packages, or the like. An optical fiber receptacle or a pigtail is attached to the laser module. In this case, since the back-reflection tolerance is high, an optical element such as an isolator does not have to be mounted. Thus, it is possible to realize reduction in cost of the laser module itself.

When this laser module is set as a unit, since a loss due to coupling of the surface-emitting laser element and an optical fiber is intrinsic, a critical back-reflection decreases in appearance. When the loss due to coupling is about 3 dB, in the laser module, the critical back-reflection increases by a loss of 6 dB from the surface-emitting laser element to the optical fiber and vice versa. As a result, a laser module having a surface-emitting laser element in the long wavelength band that has the critical back-refleation fextc, with which a value of the RIN at 0 GHz to 2 GHz becomes -115 dB/Hz, equal to or larger than -24 dB and the relaxation oscillation frequency fr at a bias point equal to or higher than 5 GHz is realized. This makes it possible to satisfactorily perform communication at transmission speed of 2.5 Gbps. A laser module having a surface-emitting laser element in the 1.3-$\mu$m band that has the critical back-reflection fextc, with which a value of the RIN at 0 GHz to 8 GHz becomes -115 dB/Hz, equal to or larger than -14 dB and the relaxation oscillation frequency fr at a bias point equal to or higher than 10 GHz is realized. This makes it possible to satisfactorily perform communication at transmission speed of 10 Gbps. Moreover, a laser module having a surface-emitting laser element in the 1.55-$\mu$m band that has the critical back-reflection, with which a value of the RIN at 0 GHz to 8 GHz becomes -115 dB/Hz, equal to or larger than -24 dB and the relaxation oscillation frequency fr at a bias point equal to or higher than 10 GHz is realized. This makes it possible satisfactorily perform communication at transmission speed of 10 Gbps.

According to the first and the second embodiments, the surface-emitting laser element is the surface-emitting laser element formed on the n-type substrate. However, the surface-emitting laser element is not limited to this surface-emitting laser element. The surface laser element may be a surface-emitting laser element formed on a p-type substrate. In this case, the selective oxidation layer 14 is provided on a p-side, that is, the lower multilayer mirror side and performs current confinement.

INDUSTRIAL APPLICABILITY

As described above, the present invention relates to a vertical cavity surface-emitting laser and, in particular, is useful for a surface-emitting laser element that can improve critical back-reflection tolerance and a laser module using the surface-emitting laser element.

**Claims**

1. A surface-emitting laser element in which a cavity is formed by a lower multilayer mirror and an upper multilayer mirror and an active layer is arranged between the lower multilayer mirror and the upper multilayer mirror, wherein a relaxation oscillation frequency at a bias point in the cavity is set to exceed an optical communication frequency for modulating a laser light output from the surface-emitting laser element.

2. The surface-emitting laser element according to claim 1, wherein the relaxation oscillation frequency is set by increasing a differential gain.

3. The surface-emitting laser element according to claim 1, wherein a p-type impurity is doped in a barrier layer forming the active layer.

4. The surface-emitting laser element according to claim 3, wherein a concentration of the doping is in a range between $1\times10^{18}$cm$^{-3}$ and $2\times10^{19}$cm$^{-3}$.

5. The surface-emitting laser element according to claim 3, wherein the p-type impurity includes at least one selected from a group consisting of carbon, beryllium, zinc, and magnesium.

6. The surface-emitting laser element according to claim 1, wherein in a setting of the relaxation oscillation frequency, a detuning from a gain peak wavelength at a room temperature to an oscillation wavelength at an operation is performed toward a short wavelength side.

**7.** The surface-emitting laser element according to claim 7, wherein
a value of the detuning is a value with which at least a differential gain is increased after the detuning.

**8.** The surface-emitting laser element according to claim 6, wherein
a value of the detuning is an energy shift value obtained by converting a wavelength into energy and is a value equal to or less than 20 milli-electron volts.

**9.** The surface-emitting laser element according to claim 1, wherein
an oscillation frequency is in a range between 300 nanometers and 1600 nanometers.

**10.** The surface-emitting laser element according to claim 1, wherein
a selective oxidation layer obtained by oxidizing a part of a current confinement layer containing at least aluminum and arsenide is provided to confine an injection current.

**11.** The surface-emitting laser element according to claim 1, wherein
a well layer or a barrier layer forming the active layer uses any one of $Ga_{x1}In_{1-x1}N_{y1}As_{y2}Sb_{1-y1-y2}$ ($0 \leq x1$, $y1$, $y2 \leq 1$), $Al_{x2}Ga_{x3}In_{1-x2-x3}As$ ($0 \leq x2$, $x3 \leq 1$), and $Tl_{x4}Ga_{x5}In_{1-x4-x5}As_{y3}P_{1-y3}$ ($0 \leq x4$, $x5$, $y4 \leq 1$).

**12.** The surface-emitting laser element according to claim 1, wherein
the active layer has any one of a quantum well structure, a quantum wire structure, and a quantum dot structure.

**13.** The surface-emitting laser element according to claim 1, wherein
both the upper multilayer mirror and the lower multilayer mirror are semiconductor multilayer films or dielectric multilayer films, or one of the upper multilayer mirror and the lower multilayer mirror is a semiconductor multilayer film and other of the upper multilayer mirror and the lower multilayer mirror is a dielectric multilayer film.

**14.** The surface-emitting laser element according to claim 1, wherein
the upper multilayer mirror, the active layer, and the lower multilayer mirror are formed on a gallium arsenide substrate, and
the upper multilayer mirror and the lower multilayer mirror includes a plurality of pairs of multilayer films of $Al_{x6}Ga_{1-x6}As$ ($0 \leq x6 < 1$) and $Al_{x7}Ga_{1-7x}As$ ($0 < x7 \leq 1$, $x6 < x7$) set as a pair.

**15.** The surface-emitting laser element according to claim 1, wherein
a critical back-reflection, with which a value of relative intensity noise becomes -115 decibels per hertz in a region of the optical communication frequency of 0 gigahertz to 2 gigahertz, is equal to or larger than -30 decibels, and
the relaxation oscillation frequency at the bias point is equal to or higher than 5 gigahertz.

**16.** The surface-emitting laser element according to claim 1, wherein
a critical back-reflection, with which a value of relative intensity noise becomes -115 decibels per hertz in a region of the optical communication frequency of 0 gigahertz to 8 gigahertz, is equal to or larger than -20 decibels,
the relaxation oscillation frequency at the bias point is equal to or higher than 10 gigahertz, and
an oscillation wavelength is in a 1300-nanoineter band.

**17.** The surface-emitting laser element according to claim 1, wherein
a critical back-reflection, with which a value of relative intensity noise becomes -115 decibels per hertz in a region of the optical communication frequency of 0 gigahertz to 8 gigahertz, is equal to or larger than -30 decibels,
the relaxation oscillation frequency at the bias point is equal to or higher than 10 gigahertz, and
an oscillation wavelength is in a 1550-nanometer band.

**18.** A laser module comprising:

a surface-emitting laser element in which a cavity is formed by a lower multilayer mirror and an upper multilayer mirror and an active layer is arranged between the lower multilayer mirror and the upper multilayer mirror, wherein a relaxation oscillation frequency of the surface-emitting laser element at a bias point in the cavity is set to exceed an optical communication frequency for modulating a laser light output from the surface-emitting laser element, and

the laser light emitted from the surface-emitting laser element is output to outside via an optical fiber.

19. The laser module according to claim 18, wherein
the relaxation oscillation frequency is set by doping a p-type impurity in a barrier layer forming the active layer to increase a differential gain.

20. The laser module according to claim 18, wherein
in a setting of the relaxation oscillation frequency, a detuning from a gain peak wavelength at a room temperature to an oscillation wavelength at an operation is performed toward a short wavelength side, and
a value of the detuning is a value with which at least a differential gain is increased after the detuning.

21. The laser module according to claim 18, further comprising:

a CAN-type package.

22. The laser module according to claim 18, further comprising:

an optical fiber receptacle.

23. The laser module according to claim 18, further comprising:

an optical fiber pigtail.

24. The laser module according to claim 18, wherein
a critical back-reflection, with which a value of relative intensity noise becomes -115 decibels per hertz in a region of the optical communication frequency of 0 gigahertz to 2 gigahertz, is equal to or larger than -30 decibels, and
the relaxation oscillation frequency at the bias point is equal to or higher than 5 gigahertz.

25. The laser module according to claim 18, wherein
a critical back-reflection, with which a value of relative intensity noise becomes -115 decibels per hertz in a region of the optical communication frequency of 0 gigahertz to 8 gigahertz, is equal to or larger than -20 decibels,
the relaxation oscillation frequency at the bias point is equal to or higher than 10 gigahertz, and
an oscillation wavelength is in a 1300-nanometer band.

26. The laser module according to claim 18, wherein
a critical back-reflection, with which a value of relative intensity noise becomes -115 decibels per hertz in a region of the optical communication frequency of 0 gigahertz to 8 gigahertz, is equal to or larger than -30 decibels,
the relaxation oscillation frequency at the bias point is equal to or higher than 10 gigahertz, and
an oscillation wavelength is in a 1550-nanometer band.

# FIG.1

# FIG.2

# FIG.3

Graph: CRITICAL BACK-REFLECTION (dB) vs fr (GHz) RELAXATION OSCILLATION FREQUENCY

# FIG.4

Graph: CRITICAL BACK-REFLECTION (dB) vs MODULATION DOPE AMOUNT ($cm^{-3}$)

# FIG.5

# FIG.6

# FIG.7

L3:fr=3 GHz    L7:fr=7 GHz
L4:fr=4 GHz    L8:fr=8 GHz
L5:fr=5 GHz    L9:fr=9 GHz
L6:fr=6 GHz    L10:fr=10 GHz

# FIG.8

# FIG.9

# FIG.10

## INTERNATIONAL SEARCH REPORT

International application No.

PCT/JP2005/003612

**A. CLASSIFICATION OF SUBJECT MATTER**
Int.Cl⁷ H01S5/183

According to International Patent Classification (IPC) or to both national classification and IPC

**B. FIELDS SEARCHED**

Minimum documentation searched (classification system followed by classification symbols)
Int.Cl⁷ H01S5/00-5/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
IEEE, JSTPlus(JOIS)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2002-359434 A    (Ricoh Co., Ltd.),<br>13 December, 2002 (13.12.02),<br>Abstract; Claims; Par. No. [0020]; Fig. 1<br>(Family: none) | 1,9-18,24-26<br>2-8,19-23 |
| Y | UOMI, K., 'Modulation-Doped Multi-Quantum Well<br>(MD-MQW) Lasers., I. Theory', Japanese Journal<br>of Applied Physics Part 1, Vol.29, No.1, January,<br>1990, pages 81 to 87 | 2-5,19 |
| Y | NAGARAJAN, R. et al., Semiconductor Lasers I<br>Fundamentals, Edited by Eli Kapon, Academic<br>Press, 1999, ISBN 0-12-397630-8, pages 213 to<br>217, 303 to 304 | 2-8,19-20 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>24 May, 2005 (24.05.05) | Date of mailing of the international search report<br>07 June, 2005 (07.06.05) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

International application No.

PCT/JP2005/003612

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 05-055684 A (Hitachi, Ltd.),<br>05 March, 1993 (05.03.93),<br>Par. Nos. [0002] to [0003]<br>(Family: none) | 6-8,20 |
| A | JP 11-330612 A (Sony Corp.),<br>30 November, 1999 (30.11.99),<br>Abstract; Par. No. [0021]; Fig. 8<br>(Family: none) | 15-17,24-26 |
| A | US 2002/0050596 A1 (OTSUKA et al.),<br>02 May, 2002 (02.05.02),<br>Par. No. [0010]<br>& JP 2003-008135 A      & JP 2002-204029 A<br>& JP 2004-007002 A      & US 2004/0065893 A1<br>& TW 000523971 B | 15-17,24-26 |
| Y | US 2003/0076864 A1 (SAI et al.),<br>24 April, 2003 (24.04.03),<br>Par. Nos. [0028] to [0029]; Fig. 4B<br>& JP 2003-133641 A | 21 |
| Y | WO 2001/001497 A1 (HONEYWELL INC.),<br>04 January, 2001 (04.01.01),<br>Abstract; Fig. 1<br>& JP 2003-503858 A      & EP 001192669 A<br>& AU 006339900 A      & CA 002378211 A | 22 |
| Y | US 006623178 B1 (SAKURAI et al.),<br>23 September, 2003 (23.09.03),<br>Column 5, lines 2 to 20; Fig. 1<br>& JP 2001-059923 A      & US 2004/0028352 A1<br>&CN 001293375 A      & TW 000531675 B | 23 |
| A | US 2002/0179929 A1 (TAKAHASHI),<br>05 December, 2002 (05.12.02),<br>Claim 2<br>& JP 2003-202529 A | 11 |
| A | JP 2000-332341 A (Sony Corp.),<br>30 November, 2000 (30.11.00),<br>Par. No. [0029]<br>(Family: none) | 15-17,24-26 |

Form PCT/ISA/210 (continuation of second sheet) (January 2004)

**EP 1 729 384 A1**

## REFERENCES CITED IN THE DESCRIPTION

**Patent documents cited in the description**

- JP 2004015027 A